(19) Europäisches Patentamt
European Patent Office
Office européen des brevets

(11) Publication number: 0 318 824 A2

(12) # EUROPEAN PATENT APPLICATION

(21) Application number: 88119545.7

(22) Date of filing: 24.11.88

(51) Int. Cl.4: C08G 59/30 , C08G 59/32 , H01B 3/40 , C08L 63/00

(30) Priority: 30.11.87 US 126389

(43) Date of publication of application: 07.06.89 Bulletin 89/23

(84) Designated Contracting States: AT BE CH DE ES FR GB GR IT LI NL SE

(71) Applicant: THE DOW CHEMICAL COMPANY
2030 Dow Center Abbott Road P.O. Box 1967
Midland Michigan 48640-1967(US)

(72) Inventor: Benkendorfer, Kyle B.
Route 2 Box 1143 P.O. Box 3117B
Freeport Texas 77541(US)
Inventor: Pham, Ha Quoc
410 North Yaupon
Richwood Texas 77531(US)
Inventor: Fritz, David B.
529 Sycamore
Lake Jackson Texas 77566(US)

(74) Representative: Sternagel, Hans-Günther, Dr. et al
Patentanwälte Dr. Michael Hann Dr. H.-G. Sternagel Sander Aue 30
D-5060 Bergisch Gladbach 2(DE)

(54) **Curable compositons and electrical or electronic components or devices encapsulated therewith.**

(57) The chemical and/or thermal stability properties of curable compositions containing glycidyl ethers of brominated biphenols or brominated bisphenols and a curing agent therefor are improved when the halogen atoms are in the meta position with respect to the ether oxygen atoms.

EP 0 318 824 A2

# CURABLE COMPOSITIONS AND ELECTRICAL OR ELECTRONIC COMPONENTS OR DEVICES ENCAPSULATED THEREWITH

The present invention concerns curable compositions suitable for encapsulating electrical or electronic components and electrical or electronic components encapsulated therewith.

There have been increasing improvements in electrical components such as microchips, including semiconductors and memory devices which have become more densely populated with electrical circuitry. With these improvements, these components have become more and more sensitive to the characteristics of the binder formulations employed in encapsulating these advanced electrical components. Halogenated, particularly brominated, epoxy resins have been employed as the binder in these encapsulated electrical components. These halogenated epoxy resins have been halogenated in the ortho position relative to the ether oxygen atom. It has been discovered that these ortho halogenated epoxy resins result in formulations for use in electrical applications which are unacceptably sensitive to moisture, increasing use temperatures, mechanical shock, and thermal shock. It would be desirable to have curable compositions containing halogenated epoxy resin binders which are more thermally and chemically stable; therefore resulting in encapsulated electrical components having an improvement in one or more of the properties including moisture resistance, glass transition temperature, dielectric constant, dissipation factor, thermal shock and device reliability testing.

The present invention concerns an improvement in curable compositions comprising, at least one brominated epoxy resin and a curing amount of at least one curing agent for the epoxy resin; wherein the improvement resides in employing as the brominated epoxy resin one or more such resins represented by the following formulas I or II

Formula I

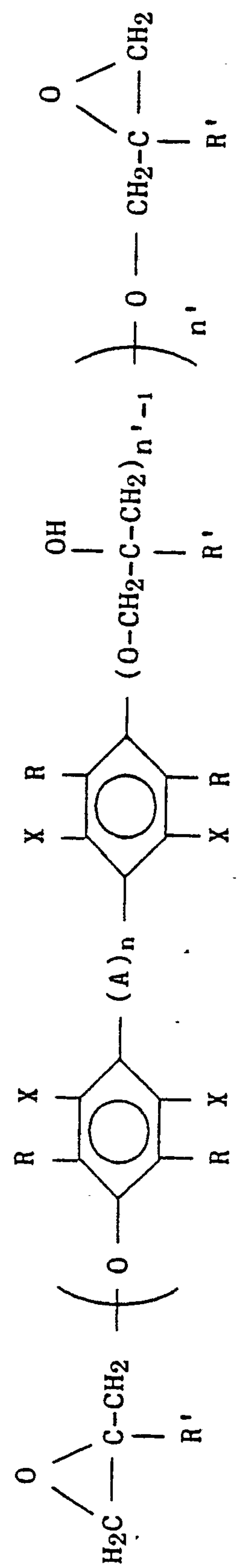

Formula II

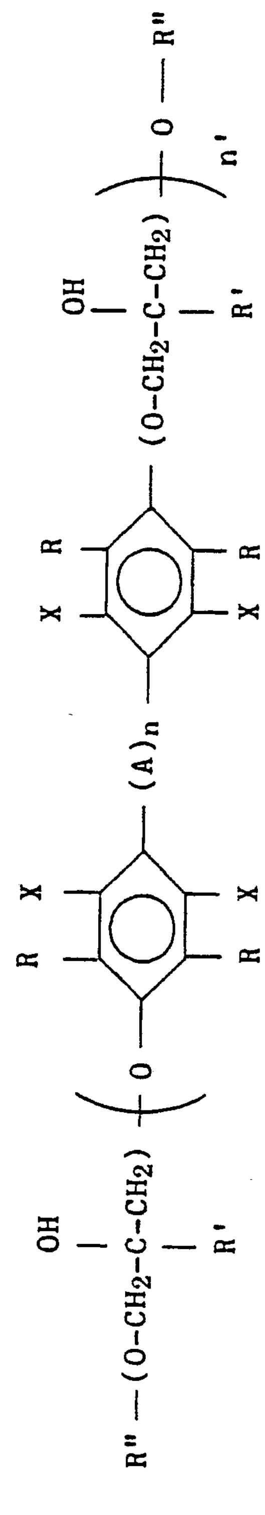

wherein each A is independently a divalent hydrocarbon group having suitably from 2 to 12, more suitably from 2 to 6, most suitably from 2 to 3, carbon atoms; each R is independently a lower alkyl group having from 1 to 3 carbon atoms; each R′ is independently hydrogen or a lower alkyl group having from 1 to 4 carbon atoms; each R″ is independently represented by the following formulas III, IV, V or VI

Formula III

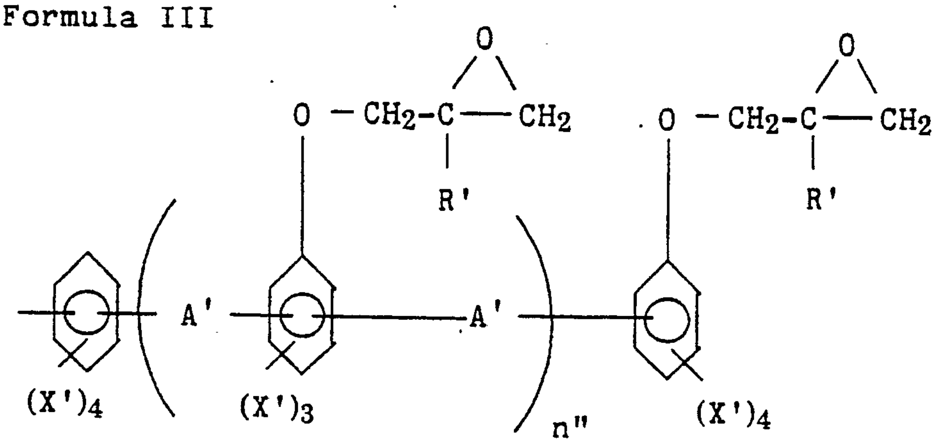

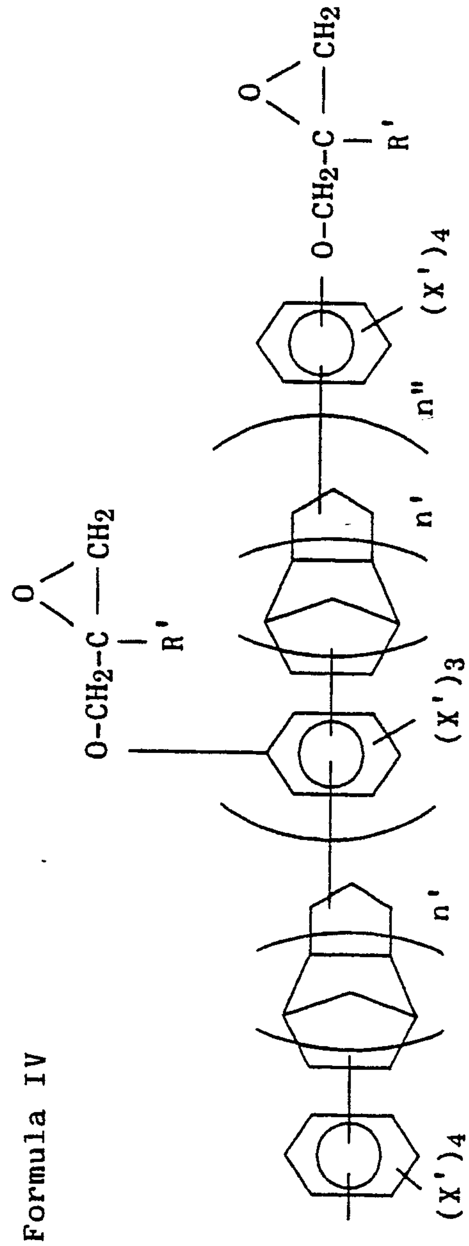

Formula IV

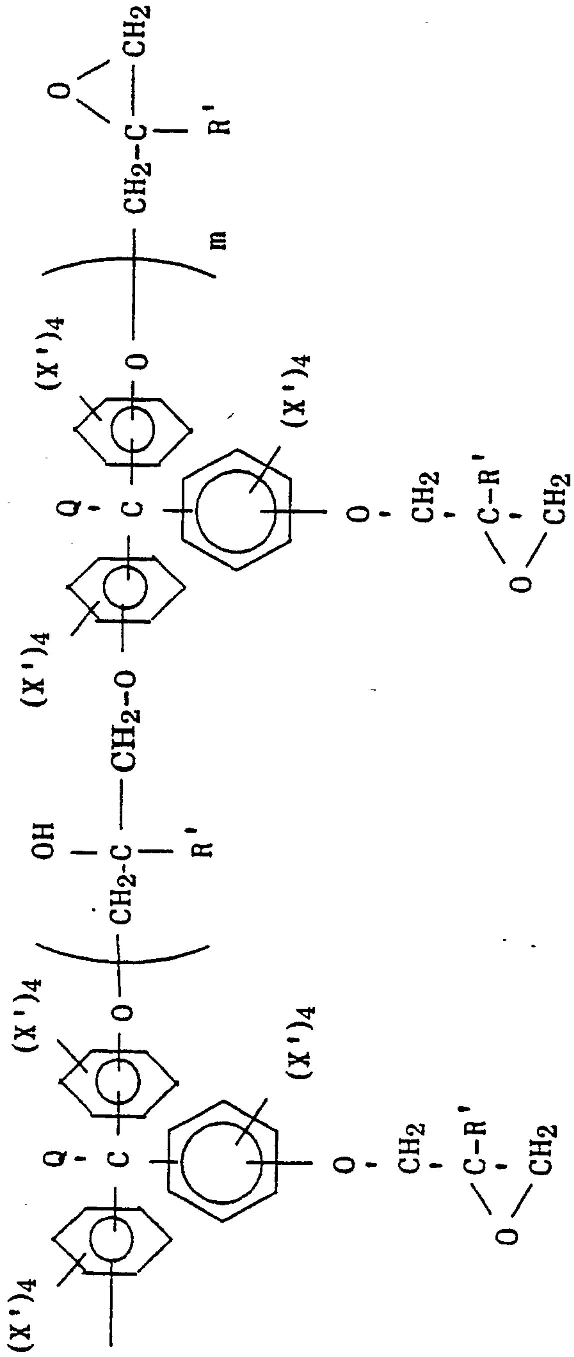

Formula V

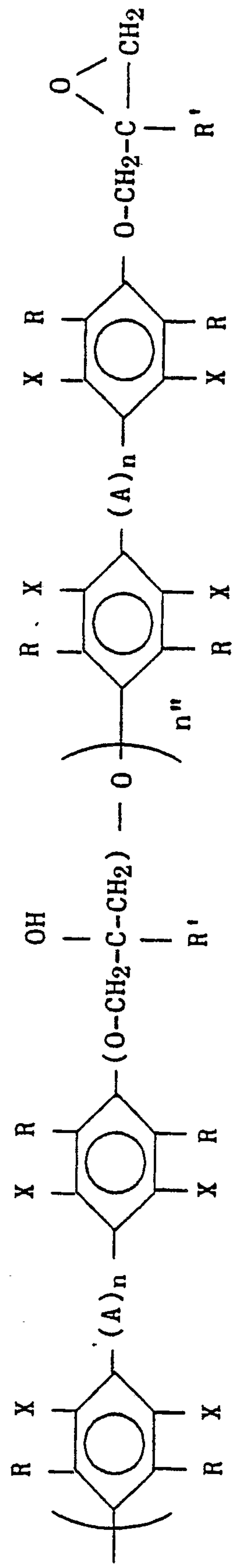

Formula VI

each X is independently hydrogen or bromine with at least one X on each ring being bromine; each X′ is independently hydrogen, a halogen or an alkyl group having from 1 to 3 carbon atoms; each A′ is independently a divalent aliphatic hydrocarbon group having suitably from 1 to 6, more suitably from 1 to 2, carbon atoms; each Q is independently hydrogen or an alkyl group having from 1 to 3 carbon atoms; m has an average value suitably from zero to 10, more suitably from zero to 5, most suitably from zero to 3; each n is independently zero or 1; n′ has an average value suitably from 1 to 10, more suitably from 1 to 4, most suitably from 1 to 2; and n″ suitably has an average value from zero to 20, more suitably from 1 to 10, most suitably from 2 to 5.

Another aspect of the present invention pertains to electrical or electronic devices or components encapsulated with the above curable composition.

These curable compositions and/or electrical or electronic devices or components have improved chemical and thermal stability and result in electrical components having an improvement in one or more of the properties including device reliability, stress, storage stability at high temperatures, and thermal shock.

The encapsulating compositions of the present invention can be prepared by blending all of the components together suitably at a temperature of from 60° C to 125° C, more suitably from 65° C to 95° C, most suitably from 75° C to 85° C.

The brominated epoxy resins employed in the encapsulating compositions of the present invention can be prepared by the procedure described in U.S. Patent 4,499,255 in which the phenolic compounds are reacted with epichlorohydrin using sodium hydroxide and a glycol ether co-solvent. Typical reaction conditions are: 1 equiv. of brominated phenolic compound is dissolved in 5 equiv. of epichlorohydrin and 3 parts by weight of a glycol ether to 7 parts by weight of epichlorohydrin is added to the mixture. 50% sodium hydroxide solution is added slowly over a 1 hour period while the temperature is controlled at 65° C and the pressure is 165 mm Hg. After caustic addition is completed, excess epichlorohydrin and glycol ether are distilled off to recover the epoxidized product.

The curable compositions of the present invention can, if desired, contain non-brominated epoxy resins. Suitable such non-brominated epoxy resins which can be employed in the present invention include, for example, any of the non-halogenated glycidyl ethers of polyhydric phenols, such as the diglycidyl ethers of biphenol, bisphenol A, bisphenol F, bisphenol S, bisphenol K and combinations thereof. Also suitable are the multifunctional epoxy resins such as the glycidyl ethers of phenol or substituted phenol-aldehyde resins such as phenol-formaldehyde epoxy novolac resins, cresol-formaldehyde epoxy novolac resins, and combinations thereof. Also suitable are the trifunctional epoxy resins such as the triglycidyl ethers of trihydroxyphenyl alkanes of which the trigylcidyl ether of trihydroxyphenyl methane is particularly suitable.

Suitable curing agents which can be employed in the present invention include, for example, amines, acids or anhydrides thereof, biguanides, guanidines, imidazoles, urea-aldehyde resins, melamine-aldehyde resins, alkoxylated urea-aldehyde resins, alkoxylated, melamine-aldehyde resins, phenolics, halogenated phenolics, and combinations thereof. These and other curing agents are disclosed in Lee and Neville's Handbook of Epoxy Resins, McGraw-Hill Book Co., 1967. Particularly suitable curing agents include, for example, dicyandiamide, methylenedianiline, diaminodiphenylsulfone, 2-methylimidazole, diethylenetoluenediamine, bisphenol A, tetrabromobisphenol A, phenol-formaldehyde novolac resins, halogenated phenol-formaldehyde novolac resins, the maleic anhydride adduct of methylcyclopentadiene (Nadic methyl anhydride), and combinations thereof. When the curing agent is a halogenated phenolic, it is preferred that the halogen atoms be in the meta position relative the the hydroxyl groups.

The compositions of the present invention can optionally contain catalysts or promoters or accelerators, fillers, pigments, dyes, mold release agents, fire retardant additives, coupling agents, and combinations thereof. These additional components are employed in functionally effective amounts to accomplish the task for which they are employed. For example, the catalysts or promoters or accelerators are employed in amounts suitable to catalyze, promote or accelerate the reaction between the epoxy resin and the curing agent; the mold release agent is employed in an amount which is suitable to cause easy release of the molded or encapsulated article from the mold; the silane coupling agent is employed in an amount which is suitable to cause the reduction of internal stress, primarily the mismatch of thermal expansion coefficients between the fillers and cured epoxy matrix; and so on for the other suitable additives. These functionally equivalent amounts are well known to those skilled in the art of molding and encapsulation.

Suitable filler materials which can be employed herein include, for example, finely divided silica flour, quartz, calcium silicate, barium sulfate, hydrated alumina, and combinations thereof. Filler selection will have varying effects on moisture permeation through the molded or encapsulated piece. The filler material(s) are usually employed in amounts ranging suitably from 1 to 95, more suitably from 50 to 80, most suitably from 65 to 75, percent by weight based upon total formulation.

Suitable catalysts or promoters or accelerators which can be employed herein include, for example,

tertiary amines, imidazoles, phosphonium compounds, ammonium compounds, sulfonium compounds, phosphines, and mixtures thereof. The catalysts or promoters or accelerators are employed in amounts corresponding suitably from zero to 10, more suitably from zero to 3, most suitably from 0.2 to 2 percent by weight based upon the weight of total amount of epoxy resin in the formulation.

Suitable imidazoles include, for example, 2-methylimidazole, 1-propylimidazole, and combinations thereof.

Suitable phosphonium compounds include, for example, those disclosed by Dante et al in U.S. Patent 3,477,990, Perry in Canadian Patent 893,191 and U.S. Patent 3,948,855 and by Tyler, Jr. et al in U.S. 4,366,295.

Suitable quaternary ammonium compounds include, for example, benzyl trimethyl ammonium chloride, benzyl trimethyl ammonium hydroxide, tetrabutyl ammonium chloride, tetrabutyl ammonium hydroxide, and combinations thereof.

A suitable phosphine includes, for example, triphenyl phosphine.

The other additives which can be employed, if desired, such as the fire retardants, mold release agent, coupling agents, pigments, and dyes, can each be employed in amounts ranging suitably from zero up to 3, more suitably up to 2, most suitably up to 1 percent by weight based upon the weight of the total formulation.

The curable compositions of the present invention are suitable for use in encapsulating electrical and electronic devices. They are particularly suitable for encapsulating micro circuitry typically found in discrete devices and integrated circuits.

The present invention will further be described with reference to the following examples.

The following components were employed in the examples and comparative experiments.

**EPOXY RESIN A** is a cresol-formaldehyde epoxy novolac resin having an average functionality of 5.5, a viscosity of 372 centistokes at 150 °C and an epoxide equivalent weight (EEW) of 216.

**EPOXY RESIN B** is a solid diglycidyl ether of tetra-o-brominated bisphenol A having an EEW of 465, a viscosity of 240 centistokes at 150 °C and a bromine content of 47.6% by weight. The bromine atoms in this epoxy resin are ortho with respect to the ether oxygen atoms.

**EPOXY RESIN C** is a diglycidyl ether of 2,2′,6,6′-tetramethyl-3,5,5′-tribromo biphenol having an EEW of 307, a viscosity of 312 centistokes at 150 °C and a bromine content of 40% by weight. The bromine atoms in this epoxy resin are meta with respect to the ether oxygen atoms.

## PREPARATION OF MOLDING (ENCAPSULATING) COMPOSITIONS

All of the ingredients (indicated in Table I) were dry blended together and thoroughly mixed at 25 °C. This dry blended mix was then added to a two-roll mill and melt mixed for eight minutes with continuous blending to assure a uniform composition. The mill conditions were as follows: Roll #1 was at 95 °C and was rotated clockwise at 35 rpm and Roll #2 was at 65 °C and was rotated counterclockwise at 25 rpm. After eight minutes on the two-roll mill, the composition was cut off of the rolls and allowed to cool to ambient temperature, 25 °C. The composition was then pulverized into a fine powder (approximately 10-50 mesh). If not employed immediately, the molding composition was then stored in a freezer until ready to be molded.

## MOLDING OR ENCAPSULATION PROCEDURE

The compositions were transfer molded onto 14-pin LM 324 Quad operational amplifiers under the following conditions. The press employed was a 50-ton Hull press with a 1,000 psi (6,894.8 kPa) transfer ram. The molding powder (equilibrated to room temperature, 25 °C, if previously stored in a freezer) was preheated to a temperature of 80 °C with a radio frequency preheater. The preheated molding powder was then transfer molded to encapsulate the test specimens. Each test specimen was defined as ten encapsulated devices on a lead frame. The mold temperature was 177 °C with a cycle time of two minutes. The test specimens were post cured at 175 °C for four hours. The test results are reported in Table II.

## TEST PROCEDURES

Total Hydrolyzable Halide

The sample to be analyzed was saponified by KOH reflux, and the resulting halides which were extracted are titrated to a potentiometric end-point with silver nitrate solution by a potentiometric technique as follows: Weigh into a 250 ml Erlenmeyer flask, 2 grams of sample, add 30 ml of 1,4-dioxane and stir until the sample dissolves. Preset a heat source which permits the sample to begin reflux in 4-6 minutes. Add 30 ml of 3N ethanolic KOH solution and attach a condenser to the flask and heat to reflux with constant stirring. Reflux 30 minutes with the initial time (zero second) as the moment the first condensed drop of liquid falls back into the flask from the condenser. Add 20 ml of 20 percent nitric acid to the flask. Add 50 ml of deionized water; next cool the solution to room temperature. Calibrate an ion meter with an Ag/AgCl and $KNO_3$-type electrodes to read zero mV against a NaCl reference solution. Titrate the sample mixture with standard silver nitrate solution (0.0025 N in methanol), insuring that the sample mixture is spinning and the electrodes are free of resin. From the volume of titrant used, calculate the hydrolyzable chloride and hydrolyzable bromide.

Moisture Absorption

The moisture pick-up was determined by placing preweighed 1/16" (1.5875 mm) thick x 4" (101.6 mm) diameter cured disks in an autoclave at 15 psig (103.4 kPa) steam, 121 °C, for 500 hours. The disks were removed and were cooled at ambient temperature (25 °C) for about 15-30 minutes and then the disks were wiped dry and were again weighed to determine any weight difference. The results are given in Table II.

Dielectric Constant

The dielectric constant was determined by the use of a Gen Rad 1689 bridge and LD-3 cell. Test coupons approximately 3" x 3" x 1/16" (76.2 mm x 76.2 mm x 1.6 mm) were cut from each cured formulated disk and were measured with the Gen Rad 1689 bridge and LD-3 cell at ambient tempeature (25 °C). The frequencies used were 1 x $10^3$ Hz, 10 x $10^3$ Hz and 100 x $10^3$ Hz.

Device Reliability Testing

The device testing was determined by a highly accelerated stress test which involved the following conditions: 121 °C, 15 psig (103.4 kPa) steam and 25 volts bias. The device was a 14-pin LM 324 quad operational amplifier with a single passivation layer. The device was considered to fail when the quiescent power dissipation became excessive or when one or more op amps failed to output the necessary voltage and current in response to electrical signals injected into its input terminals. The percentage of devices that failed as a function of time are given in Table II.

TABLE I

| | Example 1 | Comp. Expt. A* |
|---|---|---|
| Epoxy Resin A, g | 170.7 | 176 |
| Epoxy Resin B, g | 0 | 26 |
| Epoxy Resin C, g | 31.3 | 0 |
| Curing Agent[a], g | 91 | 90 |
| TPP[b], g | 2.25 | 2.25 |
| Mold Release[c], g | 4 | 4 |
| Epoxy Silane[d], g | 4 | 4 |
| Fused Silica, g | 685 | 685 |
| Antimony Trioxide, g | 10 | 10 |
| Carbon black, g | 4 | 4 |
| Wt.% bromine in formulation | 1.25 | 1.25 |

*Not an example of the present invention.
[a]Phenol-formaldehyde novolac resin, avg. functionality of 6, and phenolic hydroxyl equivalent weight of 104 (HRJ-2210 from Schenectady Chemical).
[b]Triphenyl Phosphine.
[c]Montan waxes (OP;E) as available from Hoechst.
[d]Z-6040 from Dow Corning Corp. as a silane coupling agent to reduce the internal stress between the fillers and cured epoxy matrix.

TABLE II

| | Example 1 | Comp. Expt. A* |
|---|---|---|
| Total Hydrolyzable Chloride, ppm | 166 | 140 |
| Total Hyrolyzable Bromide, ppm | 0 | >300 |
| Total Hydrolyzable Halide, ppm | 166 | >440 |
| Moisture Absorption, % wt. gain. | 0.82 | 0.92 |
| Device Reliability, | | |
| 30% failure, hours | 210 | 115 |
| 50% failure, hours | 275 | 135 |
| 90% failure, hours | 375 | 180 |
| Tg, °C | 159 | 155 |

*Not an example of the present invention.

Thus, it can be seen from the above data that the meta-brominated epoxy resins (Example 1) provide an encapsulant with better properties than does an ortho-brominated epoxy resin (Comp. Expt. A).

## Claims

1. A curable oomposition comprising, at least one brominated epoxy resin and a curing amount of at least one curing agent for the epoxy resin; characterized by employing as the brominated epoxy resin one or more such resins represented by the following formulas I or II

Formula I

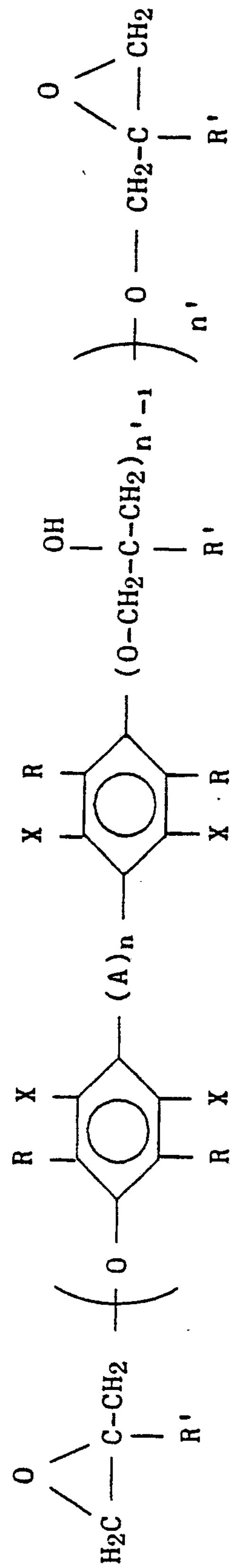

Formula II

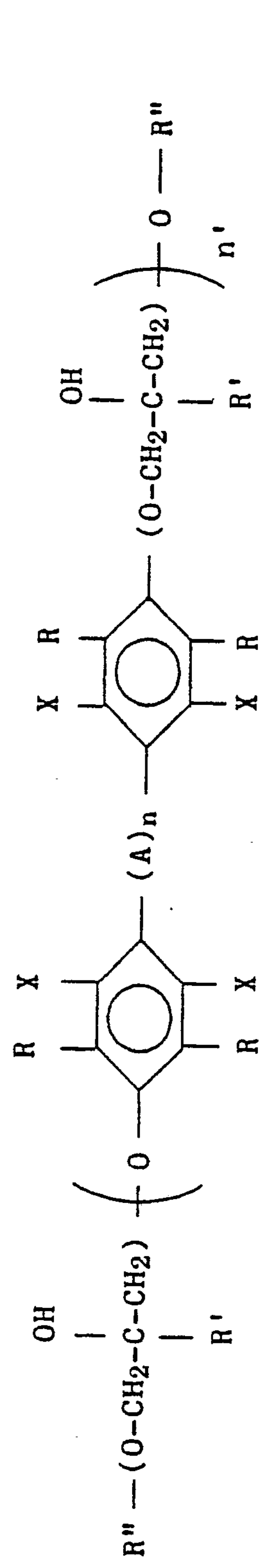

wherein each A is independently a divalent hydrocarbon group having from 2 to 12 carbon atoms; each R is independently a lower alkyl group having from 1 to 3 carbon atoms; each R′ is independently hydrogen or a lower alkyl group having from 1 to 4 carbon atoms; each R″ is independently represented by the following formulas III, IV, V or VI

Formula III

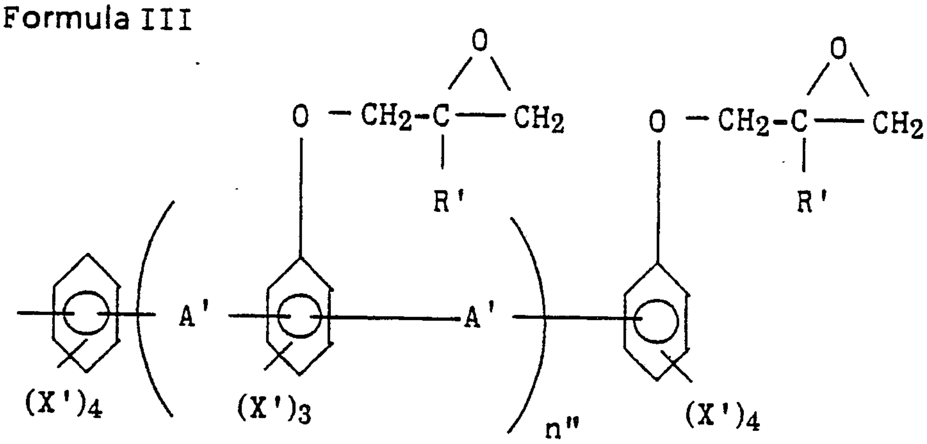

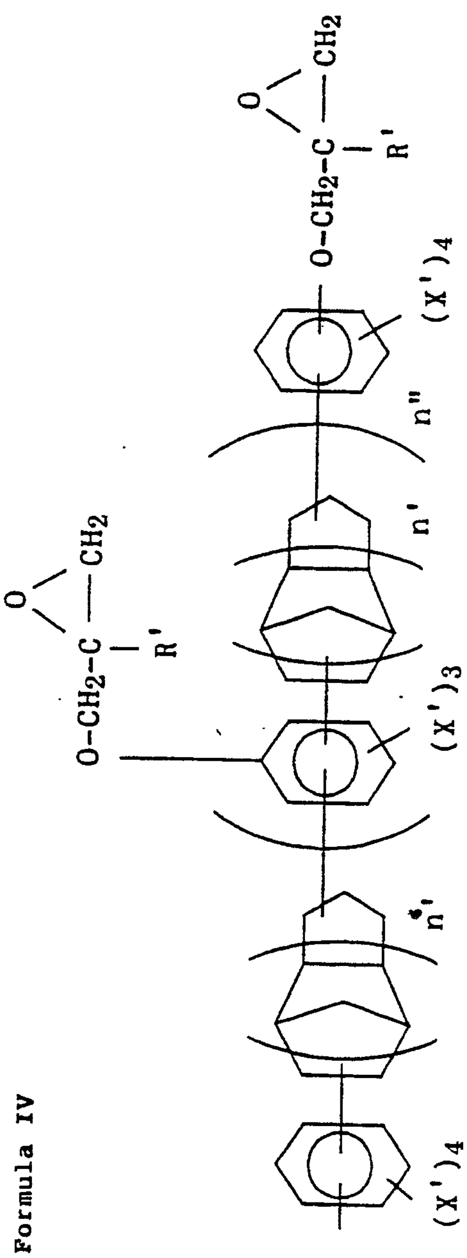

Formula IV

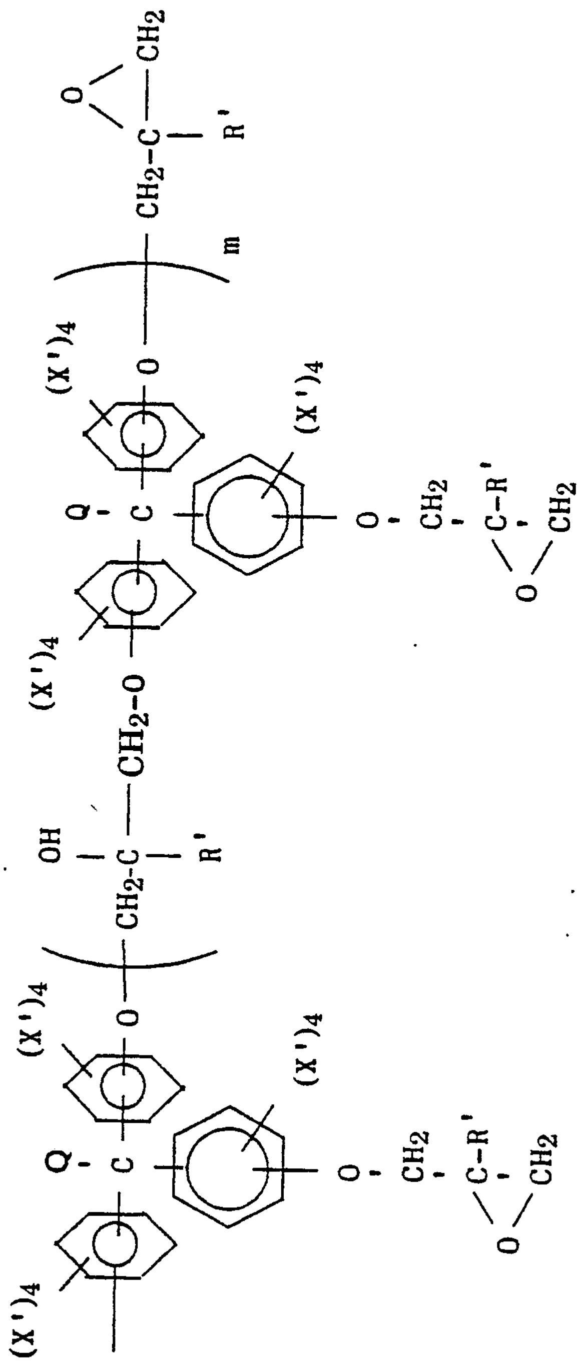

Formula V

Formula VI

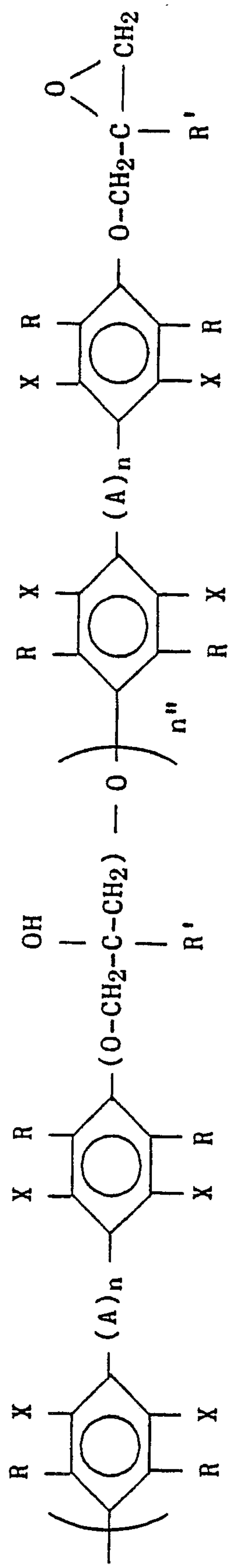

each X is independently hydrogen or bromine with at least one X on each ring being bromine; each $X'$ is independently hydrogen, a halogen, or an alkyl group having from 1 to 3 carbon atoms; each $A'$ is independently a divalent aliphatic hydrocarbon group having from 1 to 6 carbon atoms; each Q is independently hydrogen or an alkyl group having from 1 to 3 carbon atoms; m has an average value from zero to 10; each n is independently zero or 1; $n'$ has an average value from 1 to 10; and $n''$ has an average value from zero to 20.

2. A composition of Claim 1 wherein each A is isopropylidene; each $A'$ is methylene; each Q is hydrogen; each R is methyl; each $R'$ is hydrogen; m has an average value from zero to 5; $n'$ has a value of from 1 to 4; $n''$ has an average value from 1 to 10; and said curing agent is a phenolic hydroxyl-containing compound.

3. A composition of Claim 2 wherein n has a value of 1; $n'$ has a value from 1 to 2; $n''$ has an average value from 2 to 5; and said curing agent is a phenol-formaldehyde novolac resin or a cresol-formaldehyde novolac resin.

4. A composition of Claim 2 wherein n has a value of zero; $n'$ has a value from 1 to 2; $n''$ has an average value from 2 to 5; and said curing agent is a phenol-formaldehyde novolac resin or a cresol-formaldehyde novolac resin.

5. A composition of Claim 4 wherein said epoxy resin is a diglycidyl ether of 2,2',6,6'-tetramethyl-3,5,5'-tribromo biphenol.

6. A composition of Claim 1 which additionally contains from 1 to 95 percent by weight of at least one filler material based upon the weight of the total composition.

7. A composition of Claim 6 wherein the amount of filler material is from 50 to 80 percent by weight.

8. A composition of Claim 7 wherein said filler material is fused silica, antimony oxide, carbon black or a combination thereof and the amount of filler material is from 65 to 75 percent by weight based upon the total weight of the composition.

9. A composition of Claim 6 which additionally contains an effective amount of a catalyst or promoter or accelerator and an effective amount of a mold release agent and an effective amount of a silane coupling agent.

10. An electrical or electronic component or device encapsulated with the subsequently cured composition of Claim 1.